Europäisches Patentamt

European Patent Office

Office européen des brevets

(19)

(11) Publication number: **0 504 960 B1**

## EUROPEAN PATENT SPECIFICATION

(45) Date of publication of patent specification: **26.07.95**

(51) Int. Cl.$^6$: **C30B 29/38**, C30B 29/40, C30B 29/64, C30B 23/02, C23C 16/30, C01B 21/06

(21) Application number: **92200551.7**

(22) Date of filing: **26.02.92**

(54) **Phosphorus-alloyed cubic boron nitride films.**

(30) Priority: **18.03.91 US 670854**

(43) Date of publication of application:
**23.09.92 Bulletin 92/39**

(45) Publication of the grant of the patent:
**26.07.95 Bulletin 95/30**

(84) Designated Contracting States:
**DE GB IT NL**

(56) References cited:
**EP-A- 0 432 820**

**DATABASE WPI, no. 77-06 340 DERWENT
PUBLICATIONS LTD., London, GB**

**DATABASE WPI, no. 89-142 131 DERWENT
PUBLICATIONS LTD., London, GB**

(73) Proprietor: **GENERAL MOTORS CORPORA-
TION**
**General Motors Building**
**3044 West Grand Boulevard**
**Detroit**
**Michigan 48202 (US)**

(72) Inventor: **Doll, Gary Lynn**
**16015 13 Mile**
**Southfield, MI 48076 (US)**
Inventor: **Baucom, Kevin C.**
**5336 Lucile NE**
**Alburquerque, NM 87111 (US)**

(74) Representative: **Denton, Michael John et al**
**Patent Section**
**1st Floor**
**Gideon House**
**28 Chapel Street**
**Luton**
**Bedfordshire LU1 2SE (GB)**

EP 0 504 960 B1

Rank Xerox (UK) Business Services
(3.10/3.09/3.3.3)

## Description

This invention generally relates to the formation of thin films of cubic boron nitride. More particularly, this invention relates to a laser ablation method for forming these thin films wherein the cubic boron nitride film is characterized essentially by a single crystallographic structure which is in epitaxial registry with an underlying single-crystal, silicon substrate, for example as disclosed in EP-A-0 432 820, which document has an earlier priority date but which was published after the priority date of the present application.

This invention is related to parallel European patent application EP-A-0 504 959, which was filed on the same day as this patent application.

Currently within the electronics field, there is a significant demand for an insulating film which can be grown epitaxially and consistently on silicon. Such a film would greatly enhance the capabilities of silicon-based devices for operation at temperatures far exceeding the present limitations.

Boron nitride (BN) is a most interesting compound derived from the combination of a column III element of the Periodic Classification with a column V element of the Periodic Classification, from both the practical and scientific viewpoints. Boron nitride is characterized by three different crystal structures: hexagonal, wurtzite and cubic zincblende. The boron nitride phase having the cubic zincblende crystal structure is particularly useful since it is characterized by many desirable physical properties including high electrical resistivity and high thermal conductivity. In addition, boron nitride having the cubic zincblende crystal structure is relatively inert chemically. Because of these properties, this cubic form of the boron nitride is potentially very useful for electronic devices, particularly for use at high temperatures.

A cubic form of boron nitride has been grown on silicon wafers by means of a laser ablation technique, as disclosed in European patent application No.0 432 820 entitled "Laser Deposition of Crystalline Boron Nitride Films". With this laser ablation method, single crystal cubic boron nitride films were epitaxially grown on a silicon substrate oriented along the [100] axis, such that the resulting cubic boron nitride films were in epitaxial registry with the underlying silicon substrate.

As stated above, the cubic boron nitride has many characteristics useful for high temperature electronic applications. However, in order to successfully grow the cubic boron nitride on the silicon films, the crystallographic lattice for the cubic boron nitride must expand to match the lattice constant of the underlying silicon. In particular, the cubic boron nitride films formed on the silicon substrate by the laser ablation method described above, are characterized by a crystallographic lattice constant of approximately 0.384 nanometres as compared to the lattice constant of approximately 0.362 nanometres for bulk cubic boron nitride powder. The lattice constant for the cubic boron nitride films formed by the laser ablation method is approximately 5 percent larger than the bulk material. Because of this lattice expansion, two cubic boron nitride unit cells can fit along the [110] silicon direction, so as to result in epitaxial registry between the silicon and cubic boron nitride.

Although this lattice expansion brings the cubic boron nitride into crystallographic registry with the underlying single crystal silicon lattice, a large dislocation energy is always associated with a lattice expansion of this magnitude. It is believed that this large dislocation energy may be accommodated by the presence of pin-holes within the film. Without these pin-holes, or some other vehicle for accommodating this large dislocation energy, the cubic phase for boron nitride is energetically unfavourable.

However, the pin-holes present serious engineering problems within the electronic devices formed from these films. One problem is that there is a substantial electrical current leakage through the holes. This effect, as well as other less serious problems, if uncorrected, makes the cubic boron nitride a less desirable insulator as compared to other materials, such as amorphous silicon dioxide, for example.

Therefore, it would be desirable to alleviate this pin-hole problem and provide an epitaxial insulator for silicon which has a lattice constant similar to the lattice constant of the underlying silicon, and which thereby avoids the shortcomings of the art. In particular, it would be desirable to provide an epitaxial insulator which is characterized by a lattice constant which is substantially equal to the lattice constant of the underlying single crystal silicon substrate, so as to minimize or avoid the lattice mismatch and expansion of the epitaxially-grown insulating film. An epitaxial film having the thermal and physical characteristics of cubic boron nitride, but with a matched lattice in epitaxial registry with the underlying silicon, would be an excellent candidate for high-temperature electronic devices.

A method for forming thin films of boron nitride according to the present invention is characterised by the novel features specified in claim 1.

It is the primary object of this invention to provide an epitaxial insulating layer which is in crystallographic registry with an underlying single crystal silicon substrate.

It is a further object of this invention that such an epitaxial insulating layer should have a crystallographic lattice constant essentially similar to the crystallographic lattice constant of the underlying silicon substrate.

Lastly, it is still a further object of this invention that such an epitaxial insulating layer should be provided by a cubic boron nitride layer which has been appropriately alloyed with phosphorus.

In accordance with a preferred embodiment of this invention, these and other objects and advantages are accomplished as follows.

Thin films of phosphorus-alloyed boron nitride are provided on single crystal silicon substrates. The thin films of phosphorus-alloyed boron nitride are in crystallographic registry with the underlying single crystal silicon substrate.

The thin films of phosphorus-alloyed boron nitride are formed in the following manner. Firstly a single crystal silicon substrate, preferably oriented along the [100] crystallographic axis, is provided. The silicon substrate is disposed in proximity to an appropriate target. The target consists of boron nitride which has been alloyed with a predetermined amount of phosphorus. An appropriate laser is used to induce vaporization of the phosphorus-alloyed boron nitride target. The vaporized material deposits onto a surface of the silicon substrate to form a thin film layer of phosphorus-alloyed boron nitride, which is in epitaxial registry with the underlying silicon substrate. The interface between the phosphorus-alloyed boron nitride film and the silicon substrate is characterized by matched crystallographic lattice constants.

An inventive feature of this invention is that the thin film layer of phosphorus-alloyed boron nitride is characterized by essentially a single crystal cubic structure which is crystallographically aligned with the underlying silicon substrate and which has a matched crystallographic lattice with the underlying substrate. The phosphorus-alloyed boron nitride film has a crystallographic lattice constant which can be varied depending upon the desired film composition and processing parameters. Preferably, the boron nitride target, and correspondingly also the resulting thin film composition, has a chemical composition of $BN_{(1-x)}P_{(x)}$ where x is about 0.23. This particular composition results in a crystallographic lattice constant of approximately 0.383 nanometres which essentially aligns with the underlying lattice constant of the single crystal silicon substrate. The resulting films are particularly suitable for semi-conducting applications over a wide range of temperatures.

In addition, it is foreseeable that the phosphorus-alloyed boron nitride films could be deposited in such a manner so as to form a gradient throughout the film. The chemical composition would be approximately $BN_{0.77}P_{0.23}$ at the silicon - boron nitride interface for a matched crystallographic lattice structure between the two materials and would gradually decrease to a phosphorus concentration of zero, so as to provide a pure boron nitride surface for any particular applications where a surface of pure boron nitride is desired. This gradient would be achieved by varying the target composition during the laser ablation process.

Other objects and advantages of this invention will be better appreciated from the detailed description thereof, which follows.

Thin films of phosphorus-alloyed boron nitride are provided on single crystal silicon substrates. The thin films of phosphorus-alloyed boron nitride are lattice-matched and in crystallographic registry with the underlying single crystal silicon substrate.

By alloying cubic boron nitride with an appropriate amount of phosphorus, a cubic ternary compound having the elemental chemical formula, $BN_{(1-x)}P_{(x)}$ where x represents the phosphorus concentration, is achieved. The ternary crystallographic lattice constant can be systematically varied from that of pure cubic boron nitride to that of pure cubic boron phosphide, if desired. Since cubic boron nitride and cubic boron phosphide are both compounds derived from the combination of a column III element of the Periodic Classification with a column V element of the Periodic Classification , characterized by the cubic zincblende crystal structure, the relationship between the ternary lattice constant (a) and the phosphorus concentration (x) is expressed by the following equation:

$$a = 0.362\ (1\text{-}x)\ +\ 0.454\ (x)$$

where 0.362 and 0.454 are the crystallographic lattice constants in nanometres for bulk cubic boron nitride (BN) and bulk cubic boron phosphide (BP), respectively. For x equal to 0.23, or $BN_{0.77}P_{0.23}$, a ternary lattice constant of a equal to 0.383 nanometres is obtained.

The ternary compound, $BN_{0.77}P_{0.23}$, will grow along a preferred orientation on the underlying single crystal silicon substrate. The underlying single crystal silicon substrate is oriented along the [100] axis, so as to expose the preferential orientation for epitaxial growth. The [100] axis of the phosphorus-alloyed cubic boron nitride compound, $BN_{0.77}P_{0.23}$, will preferentially grow in a direction parallel to the [110] silicon plane. This results in the [010] axis of the phosphorus-alloyed cubic boron nitride compound being parallel to the [112] silicon plane; and the [001] axis of the phosphorus-alloyed cubic boron nitride compound being parallel to the [111] silicon plane.

The resulting film of the preferred cubic boron nitride-phosphide compound is characterized by a matched interface between the film and underlying silicon substrate, thereby minimizing any stresses due to a mismatched lattice. This accordingly results in a higher quality interface between the materials and better electrical properties. Correspondingly, any device formed from this material would be of a higher quality than one formed from materials having mismatched lattice constants.

In particular, the 0.383 nanometre lattice constant of the preferred cubic boron nitride-phosphide compound, $BN_{0.77}P_{0.23}$, is particularly well-suited to the silicon substrate. Since silicon has a diamond-like crystallographic structure with a lattice constant of approximately 0.542 nanometres, two of the cubic boron nitride-phosphide compounds will fit across the [110] diagonal of the silicon lattice, i.e., the lattice constant for the preferred cubic boron nitride compound of 0.383 nanometres equals 0.542 nanometres divided by $2^{1/2}$. In this preferred orientation for growth, any of the elements, boron, nitrogen or phosphorus, will reside over the silicon atoms. Therefore, the preferred phosphorus-alloyed cubic boron nitride films, having the chemical composition of $BN_{0.77}P_{0.23}$ may be grown hetero-epitaxially on the [100] silicon.

The preferred method for forming the preferred phosphorus-alloyed cubic boron nitride films utilizes laser ablation techniques, such as described in the co-pending European patent application, No.0 432 820. Generally, a boron nitride target containing polycrystalline, hexagonally-oriented, pyrolytic boron nitride which has been alloyed and sintered with the preferred amount of phosphorus $(BN_{0.77}P_{0.23})$ is provided on a rotating turntable and appropriately located in spaced relationship to the single-crystal silicon substrate within a stainless steel 6-way cross-chamber which is evacuated to an appropriately low pressure. The single crystal substrate is heated to approximately 400°C to ensure good adhesion and crystal growth, and the temperature is maintained during the ablation and deposition process. Higher temperatures have been utilized, however the resulting films do not exhibit uniform crystallinity throughout. It has been determined that a temperature of up to about 400°C provides the optimum crystallographic results within the film.

Preferably, a KrF excimer laser source operating at an appropriate wavelength and frequency is used as the ablating beam. The laser operates and the ablation occurs in a chamber filled with ultra-high purity nitrogen gas and laser fluencies ranging from about 1.5 to about 5.2 J/cm$^2$. The energy emitted from the laser operating at these parameters would be approximately 5 electron volts, which is approximately 20 percent higher than the disassociation energy required for disassociation of the phosphorus-alloyed boron nitride target.

The thickness of the cubic boron nitride thin films was determined to vary linearly with laser fluence and the number of laser pulses. At a laser fluence of approximately 3.9 J/cm$^2$, an average deposition rate of approximately 0.0182 nanometres (0.182 Angstroms) per pulse can be expected. For a 12,000 pulse run and a laser fluency of approximately 1.5 J/cm$^2$, a phosphorus-alloyed cubic boron nitride film having a thickness of approximately 175 nanometres would be produced. Any thickness within practical considerations could be formed with this method.

The band gap for cubic boron nitride is approximately 6 electronVolts, whilst that of cubic boron phosphide is approximately 2 electronVolts. It is believed that the band gap energy for the ternary $BN_{(1-x)}P_{(x)}$ compound will be large and at least comparable to that of cubic boron nitride for small values of x, including when x is 0.23, the preferred value for epitaxial growth and matched crystallographic lattice constants. The combination of this large band gap energy, and the small lattice mismatch with the underlying silicon substrate should make this preferred ternary compound a superior insulator for high-temperature, silicon-based semi-conducting devices. Examples would be hetero-structures for light-emitting diodes or semi-conducting lasers, as well as other devices.

In addition, with this method the phosphorus concentration can be systematically varied within the ternary $BN_{(1-x)}P_{(x)}$ compound from x = 0.23 to x = 0. With this gradual transition, the phosphorus-alloyed boron nitride film would act as a buffer layer between the underlying silicon substrate and a cubic boron nitride film, with minimal stress resulting due to the gradual change in lattice constants throughout the film. This would allow a device to take advantage of the excellent physical properties of cubic boron nitride for electronic, acoustic and tribological applications. The phosphorus composition could be varied by providing a target which is composed of discrete regions, such as a pie-shaped segmented target, wherein each region has a different predetermined concentration of phosphorus. The laser would then be focussed on each region as necessary to deposit upon the substrate, the phosphorus-alloyed boron nitride composition having the appropriate phosphorus concentration.

In addition, it is foreseeable that this laser ablation method would be used to form the preferred epitaxial phosphorus-alloyed cubic boron nitride film upon the silicon substrate, and then an alternative deposition method could be used to supplement the growth procedure. An illustrative example of such an alternative method would be metallo-organic chemical vapor deposition (MOCVD) techniques. The MOCVD method could be advantageous in that it is easy to accurately adjust and vary the chemical composition of elements, within the MOCVD chamber, thereby permitting facile changes in composition. Furthermore, the deposition rates are higher with the MOCVD technique than with this laser ablation method, particularly for boron nitride which has a low optical absorption and accordingly a low ablation rate. The material deposited by the MOCVD method would retain the cubic crystallographic registry of the phosphorus-alloyed cubic boron nitride film deposited by the laser ablation method.

It is also foreseeable that other elements may be substituted for the nitrogen and phosphorus, such as other column V elements of the Periodic Classification for nitrogen or phosphorus, and other column III elements of the Periodic Classification or tetravalent rare earth elements for boron, and deposited with this method with satisfactory results obtained.

With this method, phosphorus-alloyed cubic boron nitride films which are in crystallographic registry with an underlying silicon substrate are formed. It is foreseeable that the films would be suitable for use in high-temperature electronic applications, as well as other applications. While the present invention has been described in terms of preferred embodiments thereof, it is apparent that other forms of this method could be adopted by one skilled in the art, such as by substituting various other suggested chemical elements, or by modifying the process parameters such as the laser or the target composition. Accordingly, the scope of the present invention is to be limited only by the scope of the following claims.

## Claims

1. A method for forming thin films of boron nitride, which method comprises the steps of providing a substrate of silicon within a low-pressure chamber, which silicon substrate is oriented essentially throughout along its [100] crystallographic axis; providing a target of boron nitride in proximity to said silicon substrate, said target being formed from hexagonally-oriented boron nitride which has been alloyed with phosphorus; inducing vaporization of said target using a pulsed excimer laser operating at parameters sufficient to dissociate and vaporize said target, and depositing the vaporized material onto a surface of said substrate to form a thin film layer of phosphorus-alloyed cubic boron nitride on said surface, which thin film layer is an electrically-insulating layer which comprises essentially a cubic single crystal structure in crystallographic registry with said silicon substrate.

2. A method for forming thin films of boron nitride according to claim 1, in which the thin film layer of phosphorus-alloyed cubic boron nitride has a chemical composition of $BN_{(1-x)}P_{(x)}$, where $0 < x \leq 0.23$.

3. A method for forming thin films of boron nitride according to claim 2, in which said chemical composition of $BN_{(1-x)}P_{(x)}$ has a value of x of about 0.23.

4. A method for forming thin films of boron nitride according to claim 2, in which said laser is a KrF excimer laser source.

5. A method for forming thin films of boron nitride according to claim 2, in which said substrate is heated to a predetermined temperature sufficient to sustain crystal growth during the deposition of said thin film layer of phosphorus-alloyed cubic boron nitride on said surface.

6. A method for forming thin films of cubic boron nitride according to claim 5, in which said substrate is heated to a temperature not greater than 400°C.

7. A method for forming thin films of boron nitride according to claim 1, in which the phosphorus concentration is varied throughout the deposited film layer by providing a boron nitride target which has been alloyed with phosphorus so as to form a plurality of regions in the target which have different phosphorus concentrations from one another; heating said substrate to a predetermined temperature sufficient to sustain crystal growth on said surface of said substrate; inducing vaporization of a first of said regions on said target with said laser so as to vaporize said first phosphorus-alloyed boron nitride region which has a first phosphorus concentration; depositing said vaporized phosphorus-alloyed boron nitride having said first phosphorus concentration onto said surface of said silicon substrate to form a thin film layer of phosphorus-alloyed cubic boron nitride having said first phosphorus concentration on said surface and having the chemical composition of $BN_{(1-x)}P_{(x)}$ where $0 < x \leq 0.23$, said thin film layer of phosphorus-alloyed boron nitride being essentially said single crystal, cubic structure which is crystallographically aligned with said substrate; and repeating said step of inducing the vaporization of the phosphorus-alloyed cubic nitride target for each of said regions on said target so as to result in a phosphorus-alloyed cubic boron nitride film layer having a varying phosphorus concentration throughout the film layer.

8. A method for forming thin films of cubic boron nitride according to claim 7, in which said phosphorus concentration varies from $x \leq 0.23$ in the chemical formula of $BN_{(1-x)}P_{(x)}$ at the interface between said phosphorus-alloyed cubic boron nitride film layer and said substrate, to an x value of about zero at the opposite surface of said film layer.

9. A method for forming thin films of cubic boron nitride according to claim 7, in which said laser is a KrF excimer laser source, and said substrate is heated to a temperature not greater than 400 ° C.

**Patentansprüche**

1. Verfahren zur Bildung von dünnen Bornitridfilmen, wobei das Verfahren die Stufen der Bereitstellung eines Siliziumsubstrates innerhalb einer Niederdruckkammer, wobei das Siliziumsubstrat im wesentlichen längs seiner kristallographischen [100]-Achse orientiert ist, der Bereitstellung eines Bornitridtargets in der Nähe zu diesem Siliziumsubstrat, wobei dieses Target aus hexagonal orientiertem Bornitrid, das mit Phosphor legiert wurde, gebildet ist, der Induzierung der Verdampfung dieses Targets unter Verwendung eines gepulsten Excimerlasers, der bei ausreichenden Parametern zur Dissoziierung und Verdampfung dieses Targets arbeitet, und der Ablagerung des verdampften Materials auf einer Oberfläche dieses Substrates unter Bildung einer dünnen Filmschicht von phosphorlegiertem kubischem Bornitrid auf dieser Oberfläche umfaßt, wobei diese dünne Filmschicht eine elektrisch isolierende Schicht ist, welche im wesentlichen eine kubische Einkristallstruktur in kristallographischer Ausrichtung mit diesem Siliziumsubstrat umfaßt.

2. Verfahren zur Bildung von dünnen Bornitridfilmen nach Anspruch 1, in welchem die dünne Filmschicht aus phosphorlegiertem kubischem Bornitrid eine chemische Zusammensetzung von $(BN)_{(1-x)}P_{(x)}$ besitzt, worin $0 < x \leq 0,23$.

3. Verfahren zur Bildung von dünnen Bornitridfilmen nach Anspruch 2, in welchem diese chemische Zusammensetzung von $(BN)_{(1-x)}P_{(x)}$ einen Wert von x von etwa 0,23 hat.

4. Verfahren zur Bildung von dünnen Bornitridfilmen nach Anspruch 2, in welchem dieser Laser eine KrF-Excimerlaser-Quelle ist.

5. Verfahren zur Bildung von dünnen Bornitridfilmen nach Anspruch 2, in welchem dieses Substrat auf eine vorbestimmte Temperatur erhitzt wird, die zur Aufrechterhaltung des Kristallwachstums während der Ablagerung dieser dünnen Filmschicht von phosphorlegiertem kubischem Bornitrid auf dieser Oberfläche ausreicht.

6. Verfahren zur Bildung von dünnen Bornitridfilmen nach Anspruch 5, in welchem dieses Substrat auf eine Temperatur nicht größer als 400 ° C erhitzt wird.

7. Verfahren zur Bildung von dünnen Bornitridfilmen nach Anspruch 1, in welchem die Phosphorkonzentration innerhalb der abgelagerten Filmschicht dadurch variiert wird, daß ein Bornitridtarget bereitgestellt wird, das mit Phosphor so legiert worden ist, daß eine Vielzahl von Bereichen in dem Target mit voneinander unterschiedlichen Phosphorkonzentrationen gebildet sind, Erhitzen dieses Substrates auf eine vorbestimmte, zur Aufrechterhaltung des Kristallwachstums auf dieser Oberfläche dieses Substrates ausreichende Temperatur, Induzierung der Verdampfung eines ersten dieser Bereiche auf diesem Target mit diesem Laser, so daß dieser erste Bereich von phosphorlegiertem Bornitrid, der eine erste Phosphorkonzentration hat, verdampft wird, Ablagerung dieses verdampften phosphorlegierten Bornitrids, welches diese erste Phosphorkonzentration aufweist, auf dieser Oberfläche dieses Siliziumsubstrates zur Bildung einer dünnen Filmschicht aus phosphorlegiertem kubischem Bornitrid, welches diese erste Phosphorkonzentration aufweist, auf dieser Oberfläche und welches die chemische Zusammensetzung von $(BN)_{(1-x)}P_{(x)}$, worin $0 < x \leq 0,23$, hat, wobei diese dünne Filmschicht aus phosphorlegiertem Bornitrid im wesentlichen diese kubischen Einkristallstruktur ist, die kristallographisch mit diesem Substrat ausgerichtet ist, und Wiederholung dieser Stufe der Induzierung der Verdampfung des Targets aus phosphorlegiertem Bornitrid für jeden dieser Bereiche auf diesem Target, so daß eine Filmschicht aus phosphorlegiertem Bornitrid mit einer variierenden Phosphorkonzentration innerhalb der Filmschicht erhalten wird.

8. Verfahren zur Bildung von dünnen Bornitridfilmen nach Anspruch 7, in welchem diese Phosphorkonzentration von $x \leq 0,23$ in der chemischen Formel von $(BN)_{(1-x)}P_{(x)}$ an der Grenzfläche zwischen dieser Filmschicht aus phosphorlegiertem Bornitrid bis auf einen x-Wert von etwa null auf der gegenüberliegenden Oberfläche dieser Filmschicht variiert.

9. Verfahren zur Bildung von dünnen Bornitridfilmen nach Anspruch 7, in welchem dieser Laser eine KrF-Excimerlaser-Quelle ist und dieses Substrat auf eine Temperatur nicht größer als 400 ° C erhitzt wird.

**Revendications**

1. Procédé pour former des pellicules fines de nitrure de bore, comprenant les étapes de mise en place d'un substrat en silicium à l'intérieur d'une chambre sous basse pression, le substrat en silicium étant orienté de part en part essentiellement selon son axe cristallographique [100]; de mise en place d'une cible de nitrure de bore à proximité dudit substrat en silicium, ladite cible étant formée de nitrure de bore orienté dans le système hexagonal, qui a été allié avec du phosphore; d'induction de la vaporisation de ladite cible en utilisant un laser impulsionnel à excimère avec des paramètres de travail suffisants pour dissocier et vaporiser ladite cible; et de dépôt du matériau vaporisé sur une surface dudit substrat pour former sur ladite surface une couche pelliculaire fine de nitrure de bore cubique allié avec du phosphore, la couche pelliculaire fine étant une couche d'isolation électrique qui comporte essentiellement une structure de monocristal cubique en alignement cristallographique avec ledit substrat en silicium.

2. Procédé pour former des pellicules fines de nitrure de bore selon la revendication 1, dans lequel la couche pelliculaire fine de nitrure de bore cubique alliée avec du phosphore a la composition chimique $BN_{(1-x)}P_{(x)}$, dans laquelle $0 < x \leq 0,23$.

3. Procédé pour former des pellicules fines de nitrure de bore selon la revendication 2, dans lequel, dans ladite composition chimique $BN_{(1-x)}P_{(x)}$, x a une valeur d'environ 0,23.

4. Procédé pour former des pellicules fines de nitrure de bore selon la revendication 2, dans lequel ledit laser est une source laser à excimère KrF.

5. Procédé pour former des pellicules fines de nitrure de bore selon la revendication 2, dans lequel ledit substrat est chauffé à une température prédéfinie suffisante pour entretenir la croissance cristalline pendant le dépôt sur ladite surface de ladite couche pelliculaire fine de nitrure de bore cubique allié avec du phosphore .

6. Procédé pour former des pellicules fines de nitrure de bore cubique selon la revendication 5, dans lequel ledit substrat est chauffé à une température qui n'est pas supérieure à 400 ° C.

7. Procédé pour former des pellicules fines de nitrure de bore selon la revendication 1, dans lequel on fait varier la concentration en phosphore à travers la couche pelliculaire déposée en disposant d'une cible de nitrure de bore qui a été allié avec du phosphore de façon à former un ensemble de régions dans la cible qui ont des concentrations en phosphore différentes les unes des autres; en chauffant ledit substrat à une température prédéfinie suffisante pour entretenir la croissance cristalline sur ladite surface dudit substrat; en induisant la vaporisation d'une première desdites régions de ladite cible avec ledit laser de façon à vaporiser ladite première région de nitrure de bore allié avec du phosphore qui a une première concentration en phosphore; en déposant ledit nitrure de bore allié avec du phosphore ayant ladite première concentration en phosphore, vaporisé, sur ladite surface dudit substrat en silicium de façon à former une première couche pelliculaire fine de nitrure de bore cubique allié avec du phosphore ayant ladite première concentration en phosphore sur ladite surface et ayant la composition chimique $BN_{(1-x)}P_{(x)}$ dans laquelle $0 < x \leq 0,23$, ladite couche pelliculaire fine de nitrure de bore allié avec du phosphore étant essentiellement de ladite structure cubique monocristalline en alignement cristallographique avec ledit substrat; et en répétant ladite étape d'induction de la vaporisation de la cible de nitrure de bore cubique allié avec du phosphore pour chacune desdites régions de ladite cible de façon à obtenir une couche pelliculaire résultante de nitrure de bore allié avec du phosphore ayant uné concentration en phosphore variable à travers la couche pelliculaire.

8. Procédé pour former des pellicules fines de nitrure de bore cubique selon la revendication 7, dans lequel ladite concentration en phosphore varie de $x \leq 0,23$ dans le composé de formule chimique $BN_{(1-x)}P_{(x)}$ à l'interface entre ladite couche pelliculaire de nitrure de bore cubique allié avec du phosphore et ledit substrat, jusqu'à une valeur x d'environ 0 à la surface opposée de ladite couche pelliculaire.

**9.** Procédé pour former des pellicules fines de nitrure de bore cubique selon la revendication 7, dans lequel ledit laser est une source laser à excimère KrF, et ledit substrat est chauffé à une température qui ne dépasse pas 400° C.